# EUROPEAN PATENT APPLICATION

(11) **EP 4 242 939 A1**
(43) Date of publication of application: **13.09.2023**
(21) Application number: 21896570.5
(22) Date of filing: 09.10.2021
(51) Int. Cl.: G06N 20/00, G06F 21/62, H04W 88/08

(54) **RRU UNDERVOLTAGE RISK PREDICTION METHOD, APPARATUS, AND SYSTEM, DEVICE, AND MEDIUM**

(30) Priority: 27.11.2020 CN 202011357361
(71) Applicant: ZTE Corporation, Shenzhen, Guangdong 518057 (CN)
(72) Inventor: ZHAO, Yanliang, Shenzhen, Guangdong 518057 (CN); YU, Xiaolei, Shenzhen, Guangdong 518057 (CN)
(74) Representative: Savi, Massimiliano
(86) International application number: PCT/CN2021/122870
(87) International publication number: WO 2022/111068

(57) **Abstract**

Embodiments of the present application relate to the technical field of communications. Disclosed is an RRU undervoltage risk prediction method, comprising: obtaining a device parameter of a target RRU; inputting the device parameter of the target RRU into a prediction model, wherein the prediction model is a model obtained from a common node and a plurality of local nodes by means of federated learning, the common node is connected to each local node, and each local node comprises a plurality of RRUs; and predicting an undervoltage risk of the target RRU by using the prediction model. Further disclosed in the embodiments of the present application are an RRU undervoltage risk prediction apparatus and system, a device, and a medium.

## Description

### CROSS-REFERENCE TO RELATED APPLICATION

This application is filed on the basis of the Chinese patent application No. 202011357361.3 filed November 27, 2020, and claims priority of the Chinese patent application, the entire contents of which are incorporated herein by reference.

### TECHNICAL FIELD

The present disclosure relates to the technical field of communication, in particular to a method, a device and a system for predicting risk of under-voltage failure for a Remote Radio Unit (RRU), an electronic apparatus, and a computer-readable medium.

### BACKGROUND

The features of a Radio Remote Unit (RRU) technique lie in that the base station is divided into two parts: the near-end equipment, i.e., the Radio Server (RS), and the remote-end equipment, i.e., the RRU. The two parts are connected by optical fiber. Since the RS can be mounted in place within a suitable computer room and the RRU is mounted at the antenna end, the previous base station can be divided into two separate parts, i.e., the RS and the RRU, thus releasing the cumbersome maintenance work to the RS end. In addition, one RS can connect with several RRUs, which can not only save space, and reduce setup cost, but also improve networking efficiency.

Due to the reasons that the capacity of the rectifier module of the RRU is low, and the cable length or cable diameter of the power supply cable does not conform to the specifications, full-power under-voltage failure or capacity extension under-voltage failure of the RRU often occurs in the outfield, and the under-voltage failure of the RRU will lead to unreliable or abnormal RRU operations, such that the RRU fails to operate properly.

Although an under-voltage failure alarm is usually carried out in the case of under-voltage failure in RRU occurs, the under-voltage failure alarm fails to be carried out such that the probability of under-voltage failure in RRU reduces.

### SUMMARY

An embodiment of the present disclosure provides a method for predicting risk of under-voltage failure for a Remote Radio Unit (RRU), which includes, acquiring a device parameter of a target RRU; inputting the device parameter of the target RRU into a prediction model, where the prediction model is acquired by a federated learning through a common node and at least one local node, and the common node connects with each of the at least one local node, and each of the at least one local node includes at least one RRU; and performing a prediction of the risk of under-voltage failure for the target RRU by means of the prediction model.

An embodiment of the present disclosure provides a device for predicting risk of under-voltage failure for a Remote Radio Unit (RRU), which includes, an acquisition module, configured to acquire a device parameter of a target RRU; an input module, configured to input the device parameter of the target RRU into a prediction model, where, the prediction model is acquired by a federated learning through a common node, and at least one local node, and each of the at least one local node includes at least one RRU; and a prediction module, configured to perform a prediction of the risk of under-voltage failure for the target RRU by means of the prediction model.

An embodiment of the present disclosure provides a system for predicting risk of under-voltage failure for a Remote Radio Unit (RRU), which includes a common node and at least one local node, where initial models of the common node and each of the at least one local node are the same, and each of the at least one local node includes at least one RRU; and the common node is configured to: before a loss function of a model of each of the at least one local node converges, receive each model parameter reported by each local node, integrate each reported model parameter and update the model parameter of the model of the common node, and send the updated model parameter to each local node; and each of the at least one local node is configured to: before the loss function of the respective local node converges, calculate the model parameter of the model of the respective local node according to sample data for under-voltage failure of RRU in the respective local node, report the calculated model parameter to the common node, receive the model parameter sent by the common node, and update the model of the respective local node according to the sent model parameter; and each of the at least one local node is further configured to: after the loss function of the respective local node converges, utilize the model of the respective local node as the prediction model, acquire a device parameter of the target RRU, input the device parameter of the target RRU into the prediction model, and perform a prediction of the risk of the under-voltage failure of the target RRU by means of the prediction model.

An embodiment of the present disclosure further provides an electronic apparatus, which includes at least one processor, and a memory communicatively connected with the at least one processor; and the memory stores an instruction executable by the at least one processor which, when executed by the at least one processor, causes the processor to carry out the method as described above.

An embodiment of the present disclosure further provides a computer-readable storage medium, which stores a computer program which, when executed by a processor, causes the processor to carry out the method as described above.

### BRIEF DESCRIPTION OF DRAWINGS

One or more embodiments are illustrated in conjunction with the corresponding drawings, which do not constitute any limitation of the embodiments.
FIG. 1 depicts a flowchart showing a method for predicting risk of under-voltage failure for a Remote Radio Unit (RRU) according to Embodiment One of the present disclosure;
FIG. 2 depicts a schematic diagram showing the operating principle of the method for predicting risk of under-voltage failure for RRU according to Embodiment One of the present disclosure;
FIG. 3 depicts a schematic flowchart corresponding to FIG. 2;
FIG. 4 depicts a flowchart showing another method for predicting risk of under-voltage failure for a Remote Radio Unit (RRU) according to Embodiment One of the present disclosure;
FIG. 5 depicts a schematic block diagram showing a device for predicting risk of under-voltage failure for RRU according to Embodiment Two of the present disclosure;
FIG. 6 depicts a schematic diagram showing a system for predicting risk of under-voltage failure for RRU according to Embodiment Three of the present disclosure; and
FIG. 7 depicts a schematic diagram showing an electronic apparatus according to Embodiment Four of the present disclosure.

### DETAILED DESCRIPTION

Various embodiments of the present disclosure will be described in detail below in conjunction with the drawings to illustrate the purpose, technical scheme and advantages of the present disclosure. However, it shall be appreciated by those having ordinary skills in the art that many technical details are put forward in order to clarify the present disclosure. However, the technical solutions claimed in the present disclosure can be practiced even without these technical details and various alternations and modifications based on the following embodiments. The following embodiments are divided for the convenience of description, and should not constitute any limitation on the implementation of the present disclosure. The embodiments can be combined with and based on each other without conflict.

Embodiment One of the present disclosure provides a method for predicting risk of under-voltage failure for a Remote Radio Unit (RRU). The method includes, acquiring a device parameter of a target RRU; inputting the device parameter of the target RRU into a prediction model, where the prediction model is acquired by federated learning through a common node and at least one local node, and the common node connects with each of the at least one local node, and each of the at least one local node includes at least one RRU; and performing a prediction of the risk of under-voltage failure for the target RRU by means of the prediction model. Since the sample data of RRU under-voltage failure of a single local node is usually limited, it is inefficient to train an effective prediction model to predict the under-voltage risk of RRU through the sample data of a single local node. And through the federated learning method, an effective prediction model can be trained by integration of the sample data of multiple local nodes, so as to effectively predict the risk of under-voltage failure of RRU. Since the prediction model can be utilized to predict the risk of under-voltage failure of RRU, the operation and maintenance personnel of RRU can take effective precautions according to the prediction results, thus reducing the probability of under-voltage failure in RRUs.

It should be noted that the entity which carries out the method for predicting risk of under-voltage failure for RRU according to some embodiments of the present disclosure can be a local node. The local node may or may not be a local node that engages in federated learning. When the local node is a local node that does not engage in federated learning, the local node can obtain a prediction model from the common node to predict the risk of under-voltage failure of the target RRU. Furthermore, the reason why the federated learning method is utilized to predict the risk of under-voltage failure of RRU is not only because the sample data of under-voltage failure of a single local node is limited, but also because in recent years, international and domestic laws and regulations related to Internet information security and data information security protection have been promulgated one after another, such that the data between local nodes cannot be directly shared and utilized with each other. In the case that the data between local nodes cannot be directly shared, the target RRU is the RRU in the local node, that is, the local node utilizes the prediction model to predict the risk of the under-voltage failure of the RRU in the local node. A local node may include a plurality of base stations, and each base station includes several RRUs. In practical application, the entity which carries out the method for predicting risk of under-voltage failure for RRU according to an embodiment of the disclosure can also be a base station.

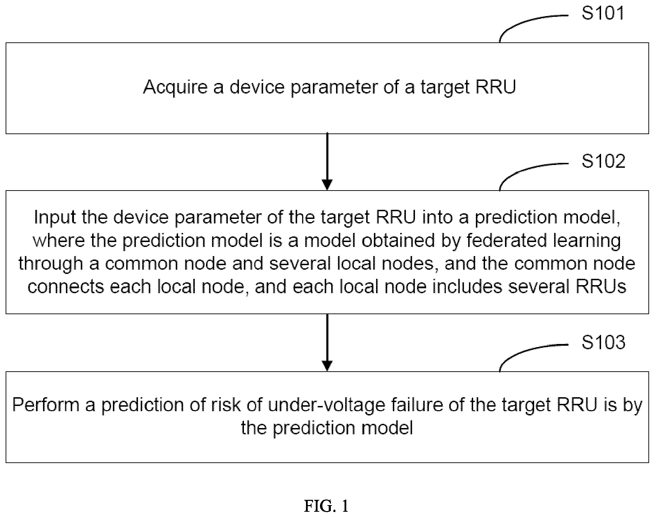

FIG. 1 depicts a flow chart showing the procedure of the method for predicting risk of under-voltage failure for RRU in an embodiment of the present disclosure. The method includes the following operations.

At S101, a device parameter of a target RRU is acquired.

In an implementation, the device parameter of the target RRU includes any one of, overall power consumption, overall input voltage, overall transmission power, RRU model, RRU identity, maximum configurable power of carrier, actual transmission power of carrier, rectifier module capacity, cable length, cable diameter, or the combination thereof.

In practical application, the RRUs included in local node(s) can be listed in a list. When predictions of the risk of under-voltage failure of RRUs are performed by the local node(s), prediction is conducted to each RRU in the list successively according to the list of RRUs. When the prediction is being conducted to a particular RRU, the device parameter(s) of the RRU is acquired for the prediction.

At S102, the device parameter of the target RRU is input into a prediction model, where the prediction model is a model obtained by federated learning through a common node and several local nodes, and the common node connects with each local node, and each local node includes several RRUs.

In an implementation, the common node and several local nodes adopt the lateral federated learning method. The initial models of the common node 301 and the local nodes 302 are the same. The prediction model can be obtained through the following federated learning process.

Each local node calculates a model parameter of the model of the local node according to the sample data of under-voltage failure of RRU(s) in the local node, and reports the calculated model parameter to the common node.

The common node integrates the reported model parameters to update the model parameters of the model of the common node, and sends the updated model parameters to each local node.

Each local node updates the model of the local node according to the sent model parameters.

The above process is repeated until the loss function of the model of the local node converges.

The prediction model is acquired according to the model of the common node or the models of the local nodes.

In particular, the model parameters transferred between local nodes and common node can include gradient, loss function, or the like. In some implementations, the model parameters are gradient values, that is, only gradient values are transferred between local nodes and common node. In order to protect the information of each local node, a local node can encrypt the gradient value and then report the same to the common node. The encryption can be done by homomorphic encryption, Differential Privacy (DP), RSA encryption algorithm. It is apparent that, due to the little-known information about the gradient values, the gradient values can be sent in plain text in order to reduce the complexity of interaction between common node and local nodes.

The sample data of RRU under-voltage failure may include samples with normal RRU or samples with RRU under-voltage failure. In an example, the samples of RRU under-voltage failure can include samples of RRU full power under-voltage failure and samples of RRU capacity extension under-voltage failure, so that the prediction model can output more detailed prediction results. The RRU sample data can include the device parameters of the RRU described above and the corresponding results of RRU under-voltage failure, so that the prediction model can predict the risk of RRU under-voltage failure according to the device parameters of the target RRU.

In practical application, open-source federated learning framework can be utilized for federated learning, such as FATE, TensorflowFederated, or PaddleFL. The utilized machine learning algorithm can be Linear Regression (LR) or Deep Neural Networks (DNN). In some implementations, the utilized machine learning algorithm is linear regression, that is, the initial models of local nodes and common node are established based on the linear regression algorithm.

In an implementation, the conditions for accepting a local node to engage in the federated learning can be set in order to enable more representative sample data of RRU under-voltage failure, and more accurate prediction results of the prediction model obtained by federated learning. The conditions can be that a ratio of the RRUs with under-voltage failure alarms in a local node to the total amount of RRUs in the local node reaches a preset threshold. The preset threshold can be set to 20%, 30%, 40%, etc. A larger threshold of the ratio can be set according to actual needs to enable more representative sample data of RRU under-voltage failure. No limitations are made to the threshold here.

The common node can be a northbound server connected with each local node. Preferably, the common node is a Network Data Analytics Function (NWDAF) server which is a new function of the 5G network. The NWDAF server is deployed as the common node. Since the NWDAF server has more efficient computing power than the northbound server, it is more effective for data integration, so that the federated learning is more efficient and the obtained prediction model is more accurate.

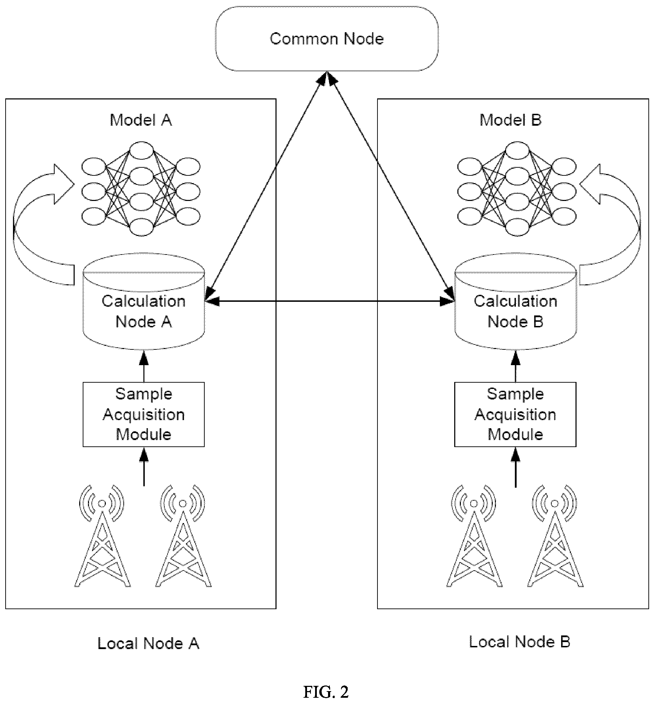

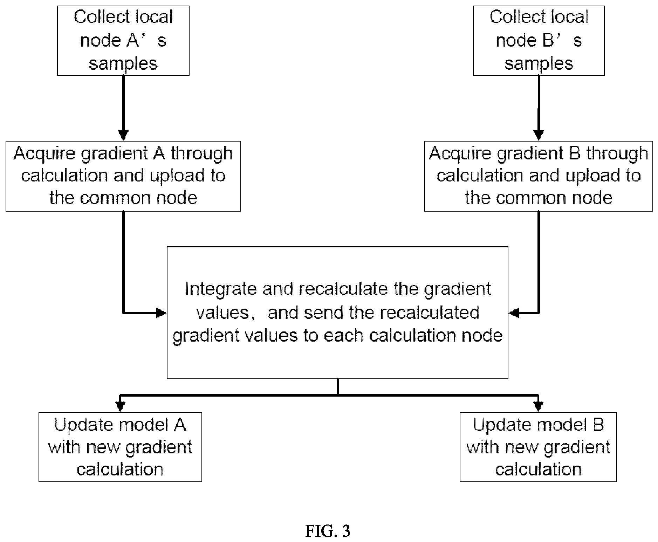

FIG. 2 depicts a schematic diagram showing the operating principle of the method for predicting risk of under-voltage failure for RRU according to this embodiment of the present disclosure, and the corresponding process is shown in FIG. 3. FIG. 2 shows two local nodes, i.e., local node A and local node B, by way of an example. Each local node includes several base station(s), and each base station includes several RRU(s). Local node A collects samples of local node A through the sample collection module thereof, and local node B collects samples of local node B through the sample collection module thereof. Local node A calculates the gradient value according to the collected samples and uploads the calculated gradient A to the common node, and local node B calculates the gradient value according to the collected samples and uploads the calculated gradient B to the common node. The common node integrates the uploaded gradient A and gradient B and recalculates the gradient value, and sends the recalculated gradient value to local node A and local node B. Local node A updates model A of the local node according to the gradient value sent by the common node, and local node B updates model B of the local node according to the gradient value sent by the common node.

At S103, an under-voltage risk of the target RRU is predicted by the prediction model.

When the sample data of RRU includes samples of normal RRU, samples of full-power under-voltage of RRU and samples of capacity extension under-voltage of RRU, the prediction results of under-voltage risk can include normal, full-power under-voltage or capacity extension under-voltage.

After obtaining the result of risk of under-voltage failure of the target RRU, processing can be carried out according to the result of risk of under-voltage failure of the RRU. For example, if the result of risk of under-voltage failure of the target RRU indicates full power under-voltage failure or capacity extension under-voltage failure, the target RRU can be checked and repaired according to the checked problems, so as to prevent the under-voltage failure of the RRU and decrease the probability of the occurrence of the undervoltage failure of the RRU. During the check, each device parameter of the target RRU can be checked. Since the reasons of the under-voltage failure of RRU lie mostly in the low capacity of the rectifier module or the cable length or cable diameter of the power supply cable does not meet the specification, after obtaining the result that indicates a risk of under-voltage failure of RRU, troubleshooting can be focused on those reasons.

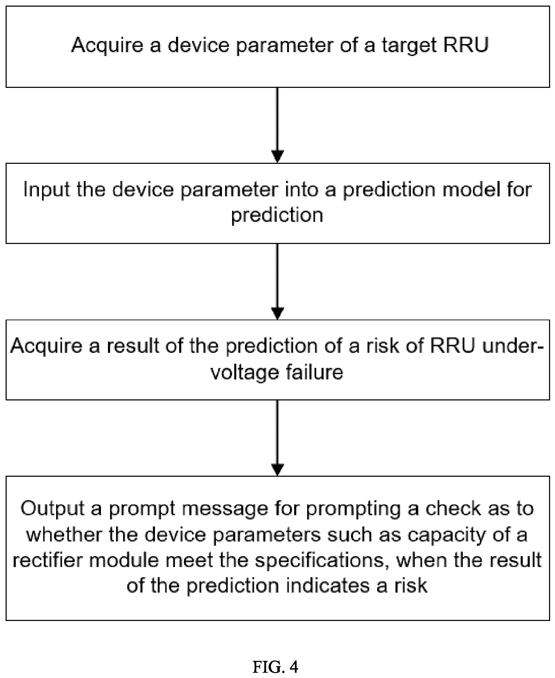

FIG. 4 depicts a schematic flow chart showing the method for predicting risk of under-voltage failure for RRU according to an embodiment of the present disclosure. In an implementation, a local node obtains the device parameters of the target RRU, and then inputs the device parameters of the target RRU into the prediction model of the local node for prediction. After the prediction of the target RRU is carried out by the local node with the prediction model, the prediction result of risk of RRU under-voltage failure output by the prediction model is acquired. When the prediction result of risk of RRU under-voltage failure indicates a risk (such as the risk of full-power under-voltage failure or capacity extension under-voltage failure), a prompt message is output for prompting a check as to whether the device parameters such as capacity of a rectifier module meet the specifications. For example, the prompt message is output to the RRU operation and maintenance management platform, so that the RRU operation and maintenance personnel can take actions and decrease the occurrence of the actual RRU under-voltage failure.

Several scenarios are illustrated by way of examples for better understanding of the above process.

### Scenario One

This scenario describes that the number of samples of a local node is insufficient, and it is inefficient to train an effective prediction model to predict the risk of RRU under-voltage failure. Through federated learning with other local nodes, an effective prediction model is trained, so as to increase the number of samples and train an accurate model.

In this scenario, it is necessary to predict the risk of under-voltage failure of RRU in local node A, but the number of samples in local node A is insufficient, so it is necessary to train an effective prediction model through federated learning. In order to enable more representative samples and more accurate prediction model obtained by training, the condition for accepting a local node to engage in the federated learning is set as follows. A ratio of RRUs with under-voltage failure alarms in a local node exceeds 30%. Assumed that, local node A has 2000 RRUs, the ratio of RRUs with under-voltage failure alarms is 35%; local node B has 3000 RRUs, the ratio of RRUs with under-voltage failure alarms is 30%; local node C has 2400 RRUs, the ratio of RRUs with under-voltage failure alarms is 32%. In such a case, the three local nodes A, B, and C are thus selected for federated learning.

The operations are as follows.
1. Each of the three local nodes respectively collects the sample data of the respective local node. The sample data includes features of, overall power consumption, overall input voltage, overall transmission power, RRU model, cable length and cable diameter, etc. And the corresponding expected results are normal, full power under-voltage failure or capacity extension under-voltage failure.
2. Calculations are carried out in the three local nodes respectively, to acquire gradients of the three local nodes.
3. The three gradients are encrypted and uploaded to the northbound server. Through the northbound server, the data of the three local nodes are integrated and the gradient values are recalculated, and the recalculated gradient values are sent to the three local nodes.
4. Three local nodes, A, B and C, update their respective models according to the sent gradient values. The above process is repeated until the loss function converges, and then a prediction model is obtained according to the converged model.
5. The device parameters of the target RRU are input into the prediction model for prediction. The operation and maintenance engineer will take measures to avoid under-voltage failure of the target RRU after obtaining the prediction results.

### Scenario Two

This scenario describes that the number of samples of a local node is sufficient but the features are insufficient, and it is inefficient to train an effective prediction model to predict the risk of RRU under-voltage failure. Through federated learning with other local nodes, an effective prediction model is trained, so as to compensate for the insufficient of the features and train an accurate model.

In this scenario, it is necessary to predict the risk of under-voltage failure of RRU in local node A. Local node A contains 20,000 RRUs, and the ratio of RRUs with under-voltage failure alarms is 40%. However, due to the project implementation, it is not possible for local node A to obtain the features of the samples, such as cable length and cable diameter, so it is inefficient for local node A to train an effective prediction model. In order to enable more representative samples and a more accurate prediction model obtained by training, the condition for accepting a local node to engage in the federated learning is set as follows. The ratio of RRUs with under-voltage failure alarms in a local node exceeds 30%. Assumed that, the samples of local node B contain two features of cable length and cable diameter, and the ratio of RRUs with under-voltage failure alarms is 35%. In such a case, two local nodes A and B are thus selected for federated learning.

The operations are as follows.
1. The two local nodes respectively collect the sample data of their own local nodes. The features of local node B include overall power consumption, overall input voltage, overall transmission power, RRU model, cable length and cable diameter, etc. The features of local node A include the features other than cable length and cable diameter. The expected results of the two local nodes are the same: normal, full power under-voltage failure, and capacity extension under-voltage failure.
2. Calculations are carried out in the two local nodes respectively, to acquire gradients of the two local nodes.
3. The two gradients are encrypted and uploaded to the northbound server. Through the northbound server, the data of the two local nodes are integrated and the gradient values are recalculated, and the recalculated gradient values are sent to each calculation node.
4. The two local nodes A and B, update their respective models according to the sent gradient values. The above process is repeated until the loss function converges, and then a prediction model is obtained according to the converged model.
5. The features of the target RRU are input into the prediction model for prediction. The operation and maintenance engineer will take measures to avoid under-voltage failure of the target RRU after obtaining the prediction results.

### Scenario Three

This scenario is basically the same as Scenario One, except that the NWDAF server is deployed as the common node.

In this scenario, it is necessary to predict the risk of under-voltage failure of RRU in local node A, but the number of samples in local node A is insufficient, so it is necessary to train an effective prediction model through federated learning. In order to enable more representative samples and more accurate prediction model obtained by training, the condition for accepting a local node to engage in the federated learning is set as follows. The ratio of RRUs with under-voltage failure alarms in a local node exceeds 30%. Assumed that, local node A has 2000 RRUs, the ratio of RRUs with under-voltage failure alarms is 35%; local node B has 3000 RRUs, the ratio of RRUs with under-voltage failure alarms is 30%; local node C has 2400 RRUs, the ratio of RRUs with under-voltage failure alarms is 32%. In such a case, the three local nodes A, B, and C are selected for federated learning.

The operations are as follows.
1. Each of the three local nodes respectively collects the sample data of the respective local node. The sample data includes features of, overall power consumption, overall input voltage, overall transmission power, RRU model, cable length and cable diameter, etc. And the corresponding expected results are normal, full power under-voltage failure or capacity extension under-voltage failure.
2. Calculations are carried out in the three local nodes respectively, to acquire gradients of the three local nodes.
3. The three gradients are encrypted and uploaded to the NWDAF server. Through the NWDAF server, the data of the three local nodes are integrated and the gradient values are recalculated, and the recalculated gradient values are sent to the three local nodes.
4. Three local nodes, A, B, and C, update their respective models according to the sent gradient values. The above process is repeated until the loss function converges, and then a prediction model is obtained according to the converged model.
5. The device parameters of the target RRU are input into the prediction model for prediction. The operation and maintenance engineer will take measures to avoid under-voltage failure of the target RRU after obtaining the prediction results.

According to the method for predicting risk of under-voltage failure for RRU set forth in various embodiments of the present disclosure, the device parameters of the target RRU are acquired and input into a prediction model obtained by federated learning through a common node and several local nodes, and the prediction model is utilized to predict the risk of under-voltage failure of the target RRU. Since the sample data of under-voltage failure of RRU of a single local node is usually limited, it is inefficient to train an effective prediction model to predict the risk under-voltage failure of RRU through the sample data of a single local node. And through the federated learning method, an effective prediction model can be trained by integration of the sample data of multiple local nodes, so as to effectively predict the risk of under-voltage failure of RRU. Since the prediction model can be utilized to predict the risk under-voltage failure of RRU, the operation and maintenance personnel of RRU can take effective precautions according to the prediction results, thus reducing the probability of under-voltage failure in RRUs.

It shall be appreciated by those having ordinary skills in the art that the processes of the above methods are divided only for clarity of description, and those processes can be combined into one single process or some processes can be divided into several processes in an implementation, any process in which identical logical relationship to the present disclosure is included shall be within the scope of the present disclosure. The algorithm or process with any minor modifications or insignificant designs which do not change the core design of the algorithm and process, shall be within the scope of the present disclosure.

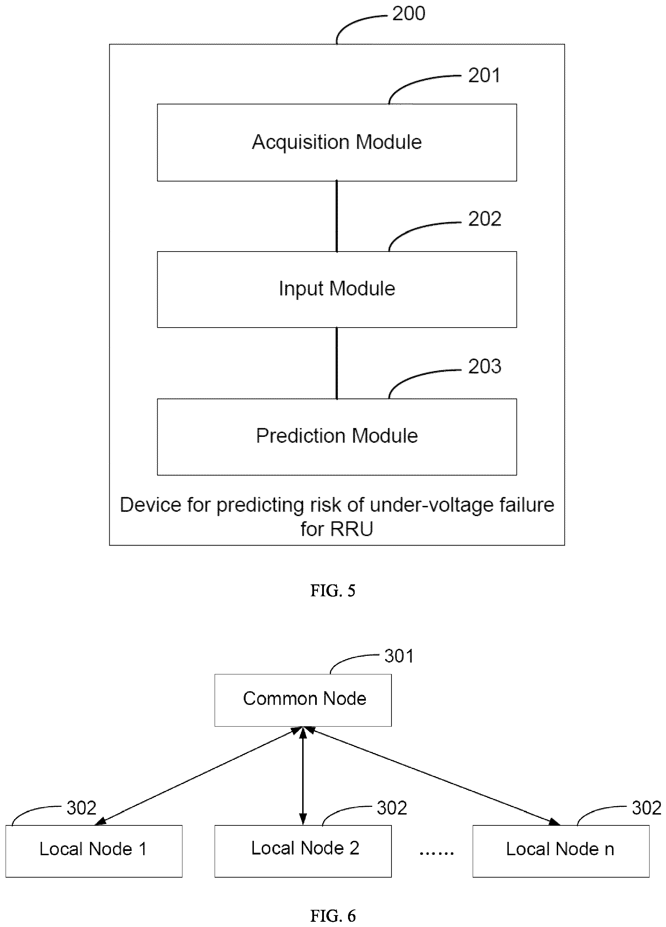

Embodiment Two of the present disclosure relates to a device 200 for predicting risk of under-voltage failure for RRU. As shown in FIG. 5, the device 200 includes an acquisition module 201, an input module 202 and a prediction module 203. And the functions of each module are described as follows.

The acquisition module 201 is configured to acquire a device parameter of a target RRU.

The input module 202 is configured to input the device parameter of the target RRU into a prediction model obtained by federated learning by a common node, and a plurality of local nodes. Each local node includes a plurality of RRUs.

The prediction module 203 is configured to predict the risk of under-voltage failure of the target RRU by the prediction model.

In an implementation, the initial models of the common node 301 and the local nodes 302 are the same. The prediction model can be obtained through the following federated learning process.

Each local node calculates a model parameter of the model of the local node according to the sample data of under-voltage failure of RRU of the local node, and reports the calculated model parameter to the common node.

The common node integrates the reported model parameters to update the model parameters of the model of the common node, and sends the updated model parameters to each local node.

Each local node updates the model of the local node according to the sent model parameters.

The above process is repeated until the loss function of the model of the local node converges.

The prediction model is acquired according to the model of the common node or the models of the local nodes.

In an implementation, the initial model is a model established based on a linear regression algorithm.

In an implementation, the device parameter of the target RRU includes any one of, overall power consumption, overall input voltage, overall transmission power, RRU model, maximum configurable power of carrier, actual transmission power of carrier, rectifier module capacity, cable length, cable diameter, or a combination thereof.

In an implementation, the results of risk of under-voltage failure include normal, full power under-voltage failure, or capacity extension under-voltage failure.

In an implementation, the local node is a local node where the proportion of under-voltage failure alarms of RRUs reaches a preset threshold, and the proportion of under-voltage failure alarms is the proportion of the number of RRUs with under-voltage failure alarms to the total number of RRUs in the local node.

In an implementation, the common node is an NWDAF server.

It is clear that this embodiment is a device embodiment corresponding to Embodiment One, and this embodiment may be practiced in cooperation with Embodiment One. The relevant technical details as described in Embodiment One can be applied to this embodiment, and which will not be repeated here for concise. Accordingly, the relevant technical details as described in this embodiment can also be applied to Embodiment One.

It should be noted that all the modules involved in this embodiment are logic modules. In practical application, a logic unit can be a physical unit, a part of a physical unit or a combination of multiple physical units. In addition, in order to highlight the innovative part of the present disclosure, units that are not closely related to solution of the technical problems as set forth in the present disclosure are not introduced in this embodiment, but this does not mean that no further unit is included in this embodiment.

Embodiment Three of the present disclosure relates to a system for predicting risk of under-voltage failure for RRU. As shown in FIG. 6, the system includes a common node 301 and several local nodes 302. The initial models of the common node 301 and the local nodes 302 are the same. And each local node 302 includes several RRU(s).

The common node 301 is configured to: receive each model parameter reported by each local node 302, integrate the reported model parameters and update the model parameters of the common node 301, and send the updated model parameters to each local node 302, before the loss function of the model of the local node 302 converges.

Each local node 302 is configured to: before the loss function of the respective local node converges, calculate the model parameter of the model of the respective local node according to sample data for under-voltage failure of RRU in the respective local node, report the calculated model parameter to the common node 301, receive the model parameter sent by the common node 301, and update the model of the respective local node according to the sent model parameter; and each local node 302 is further configured to: after the loss function of the respective local node converges, utilize the model of the respective local node as the prediction model, acquire a device parameter of the target RRU, input the device parameter of the target RRU into the prediction model, and perform a prediction of the risk of the under-voltage failure of the target RRU by means of the prediction model.

In an implementation, the initial model of the common node 301 or the local node 302 is a model established based on a linear regression algorithm.

In an implementation, the device parameter of the target RRU includes any one of, overall power consumption, overall input voltage, overall transmission power, RRU model, maximum configurable power of carrier, actual transmission power of carrier, rectifier module capacity, cable length, cable diameter, or a combination thereof.

In an implementation, the results of risk of under-voltage failure include normal, full power under-voltage failure, or capacity extension under-voltage failure.

In an implementation, the local node is a local node where the proportion of under-voltage failure alarms of RRUs reaches a preset threshold, and the proportion of under-voltage failure alarms is the proportion of the number of RRUs with under-voltage failure alarms to the total number of RRUs in the local node.

In an implementation, the common node is an NWDAF server.

It is clear that this embodiment is a system embodiment corresponding to Embodiment One, and this embodiment may be practiced in cooperation with Embodiment One. The relevant technical details as described in Embodiment One can be applied to this embodiment, and which will not be repeated here for concise. Accordingly, the relevant technical details as described in this embodiment can also be applied to Embodiment One.

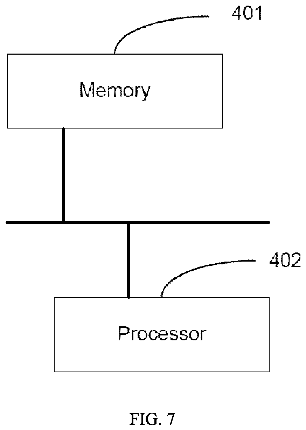

Embodiment Four of the present disclosure is directed to an electronic apparatus. As shown in FIG. 7, the electronic apparatus includes at least one processor 401, and a memory 402 in communicatively connected with the at least one processor 401, in which the memory 402 stores an instruction executable by the at least one processor 401 which, when executed by the at least one processor 401, cause the at least one processor 401 to carry out the method as described above.

The memory and the processor are connected by a bus. The bus can include any number of interconnected buses and bridges, and the bus connects various circuits of one or more processors and the memory together. The bus can also connect various other circuits, such as peripheral devices, voltage regulators, power management circuits, etc., all of which are well-known in the art, so they will not be further described here. The bus interface provides an interface between the bus and the transceiver. The transceiver can be one element or a plurality of elements, such as a plurality of receivers and transmitters, providing a unit for communicating with various other devices over a transmission medium. The data processed by the processor is transmitted over the wireless medium through the antenna. Furthermore, the antenna also receives the data and transmits it to the processor.

The processor is configured for managing the bus and general processing, and can also provide various functions, including timing, peripheral interface, voltage regulation, power management and other control functions. And the memory can be utilized to store data for the processor during operations.

An embodiment of the present disclosure relates to a computer-readable storage medium storing thereon a computer program. The computer program, when is executed by a processor, causes the processor to carry out the method in any one of the embodiments as described above.

That is, it shall be appreciated by those having ordinary skill in the art that all or part of the processes for carrying out the above-mentioned method embodiments can be implemented by instructing related hardware through a program, which is stored in a storage medium and includes several instructions to cause a device (such as a single chip, a chip, etc.) or a processor perform all or part of the processes of the methods in various embodiments of the present disclosure. The aforementioned storage media includes: U disk (flash disk), mobile hard disk, Read-Only Memory (ROM), Random Access Memory (RAM), magnetic disk or optical disk and other media that can store program codes.

It shall be understood by those having ordinary skill in the art that the above are some embodiments for implementing the present disclosure, and in practical application, various alternations in form and details can be made without departing from the scope of the present disclosure.

## Claims

1. A method for predicting risk of under-voltage failure for a Remote Radio Unit (RRU), comprising,
acquiring a device parameter of a target RRU;
inputting the device parameter of the target RRU into a prediction model, wherein the prediction model is acquired by federated learning through a common node and at least one local node, and the common node connects with each of the at least one local node, and each of the at least one local node comprises at least one RRU; and
performing a prediction of the risk of under-voltage failure for the target RRU by means of the prediction model.

2. The method according to claim 1, wherein initial models of the local node and the common node are the same, and the prediction model is acquired through operations of the federated learning comprising,
calculating, by each of the at least one local node, a model parameter of a model of the respective local node according to sample data of under-voltage failure of RRU in the respective local node, and reports the calculated model parameter to the common node;
integrating, by the common node, each reported model parameter to update a model parameter of a model of the common node, and sends the updated model parameter to each local node;
updating, by each of the at least one local node, the model of the respective local node according to the sent model parameter;
repeating the above operations until a loss function of the model of the respective local node converges; and
acquiring the prediction model according to the model of the common node or the model of the respective local node.

3. The method according to claim 2, wherein the initial model is established based on a linear regression algorithm.

4. The method of any one of claims 1 to 3, wherein the device parameter of the target RRU comprises any one of, overall power consumption, overall input voltage, overall transmission power, RRU model, maximum configurable power of carrier, actual transmission power of carrier, rectifier module capacity, cable length, cable diameter, or a combination thereof.

5. The method of any one of claims 1 to 4, wherein, the local node is a local node where a proportion of under-voltage failure alarms of RRUs reaches a preset threshold, and the proportion of under-voltage failure alarms is the proportion of a quantity of RRUs with under-voltage failure alarms to a total quantity of RRUs in the local node.

6. The method of any one of claims 1 to 5, wherein, the common node is a Network Data Analytics Function (NWDAF) server.

7. A device for predicting risk of under-voltage failure for a Remote Radio Unit (RRU), comprising,
an acquisition module, configured to acquire a device parameter of a target RRU;
an input module, configured to input the device parameter of the target RRU into a prediction model, wherein, the prediction model is acquired by federated learning through a common node, and at least one local node, and each of the at least one local node comprises at least one RRU; and
a prediction module, configured to perform a prediction of the risk of under-voltage failure for the target RRU by means of the prediction model.

8. A system for predicting risk of under-voltage failure for a Remote Radio Unit (RRU), comprising a common node and at least one local node, wherein initial models of the common node and each of the at least one local node are the same, and each of the at least one local node comprises at least one RRU; and
the common node is configured to: before a loss function of a model of each of the at least one local node converges, receive each model parameter reported by each local node, integrate each reported model parameter and update the model parameter of the model of the common node, and send the updated model parameter to each local node; and
each of the at least one local node is configured to: before the loss function of the respective local node converges, calculate the model parameter of the model of the respective local node according to sample data for under-voltage failure of RRU in the respective local node, report the calculated model parameter to the common node, receive the model parameter sent by the common node, and update the model of the respective local node according to the sent model parameter; and each of the at least one local node is further configured to: after the loss function of the respective local node converges, utilize the model of the respective local node as the prediction model to acquire a device parameter of the target RRU, input the device parameter of the target RRU into the prediction model, and perform a prediction of the risk of the under-voltage failure of the target RRU by means of the prediction model.

9. An electronic apparatus, comprising,
at least one processor; and,
a memory in communication with the at least one processor; wherein,
the memory stores an instruction executable by the at least one processor which, when executed by the at least one processor, causes the at least one processor to carry out the method of any one of claims 1 to 6.

10. A computer-readable storage medium storing a computer program which, when executed by a processor, causes the processor to carry out the method of any one of claims 1 to 6.
